(19) Europäisches Patentamt / European Patent Office / Office européen des brevets

(11) **EP 4 376 297 A1**

(12) **EUROPEAN PATENT APPLICATION**

(43) Date of publication:
**29.05.2024 Bulletin 2024/22**

(21) Application number: **23212255.6**

(22) Date of filing: **27.11.2023**

(51) International Patent Classification (IPC):
*H03F 3/387* (2006.01)     *H03F 3/45* (2006.01)
*H03F 3/347* (2006.01)

(52) Cooperative Patent Classification (CPC):
**H03F 3/347; H03F 3/393; H03F 3/45475;**
**H03F 3/45753; H03F 3/45968; H03F 3/45977;**
H03F 2200/261; H03F 2200/375; H03F 2203/45212

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **25.11.2022 KR 20220160488**
**26.06.2023 KR 20230081591**

(71) Applicant: **LX Semicon Co., Ltd.**
**Daejeon 34027 (KR)**

(72) Inventors:
• **Choi, Harim**
**34027 Daejeon (KR)**
• **Kim, Jiwon**
**34027 Daejeon (KR)**
• **Kim, Hyo Joong**
**34027 Daejeon (KR)**
• **Shin, Kyung Min**
**34027 Daejeon (KR)**
• **Ahn, Yongsung**
**34027 Daejeon (KR)**

(74) Representative: **Ter Meer Steinmeister & Partner
Patentanwälte mbB
Nymphenburger Straße 4
80335 München (DE)**

(54) **OFFSET FREE DIFFERENTIAL AMPLIFIER AND OFFSET FREE METHOD OF DIFFERENTIAL AMPLIFIER**

(57) The present invention provides an offset free differential amplifier and an offset free method of a differential amplifier capable of removing an offset of a differential amplifier by selectively using at least one of an auto zero method and a chopping method. The offset free differential amplifier includes a differential amplifier; a chopping switch unit that is connected to two input terminals and one output terminal of the differential amplifier in response to a chopping control signal and removes an average offset of the differential amplifier; and an auto-zero switch unit that is connected to the differential amplifier and the chopping switch unit in response to an auto-zero switch control signal and removes an absolute offset of the differential amplifier.

FIG. 3

EP 4 376 297 A1

## Description

## BACKGROUND

## 1. FIELD

The present invention relates to an offset free differential amplifier, and more particularly, to an offset free differential amplifier that performs at least one of an auto zero method and a chopping method which are methods of removing offset using a plurality of switches connected to input and output terminals of the differential amplifier.

## 2. DESCRIPTION OF RELATED ART

A differential amplifier amplifies a difference in voltage applied to two input terminals by a pre-designed gain and outputs the amplified voltage. In general, an operational amplifier and a differential amplifier are used interchangeably, so the differential amplifier and an amplifier to be described below may be understood as a concept including the operational amplifier.

A voltage level and names (node, $V_{out}$) of members of a node or a terminal $V_{out}$ are used interchangeably. For example, a name of a specific node $V_{out}$ (or a specific terminal) and a voltage level $V_{out}$ of a specific node will be written as $V_{out}$.

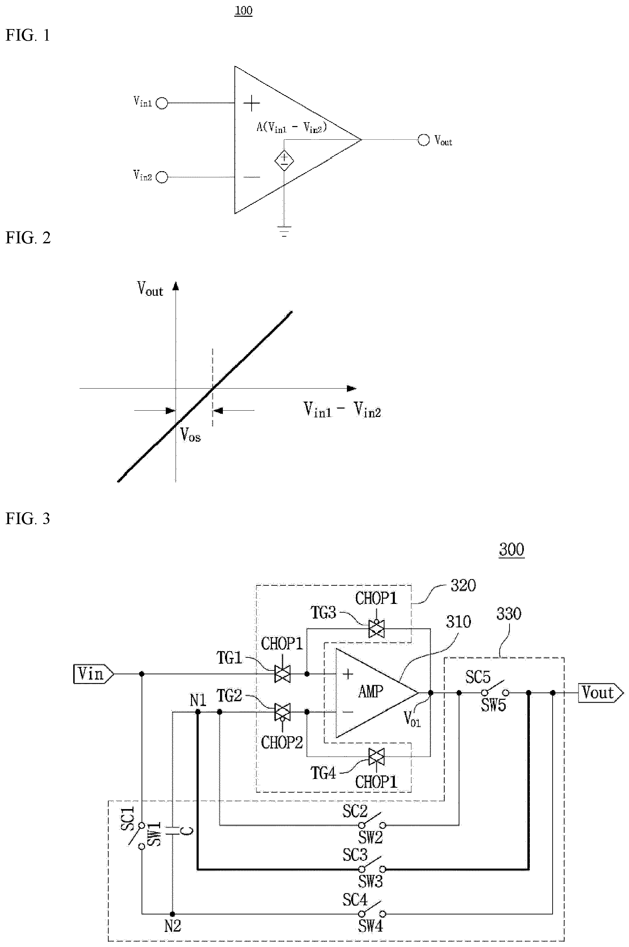

FIG. 1 is an equivalent model of a conventional differential amplifier.

Referring to the equivalent model of the differential amplifier illustrated in FIG. 1, a differential amplifier 100 amplifies a difference $V_{in1}-V_{in2}$ in voltage applied to two input terminals $V_{in1}$ and $V_{in2}$ by a gain A and outputs the amplified voltage to an output terminal $V_{out}$, and the voltage $V_{out}$ of the output terminal $V_{out}$ may be expressed as the following Equation 1.

$$[\text{Equation 1}]$$
$$V_{out} = A(V_{in1} - V_{in2})$$

Referring to the above Equation 1, when the difference between the two input voltages $V_{in1}$ - $V_{in2}$ is 0 (zero), that is, when the voltage levels $V_{in1}$ and $V_{in2}$ of the two input voltages are the same, the output voltage $V_{out}$ should be 0, but the actual output voltage $V_{out}$ of the differential amplifier does not become 0.

The differential amplifier is implemented using a plurality of elements such as a plurality of transistors, resistors, and capacitors. During manufacturing of these elements, a mismatch of the elements caused by asymmetry between the plurality of elements that constitute an input stage of the differential amplifier is the main cause of the output voltage $V_{out}$ not being 0.

FIG. is a graph for describing a concept of an offset voltage of a differential amplifier.

Referring to a graph illustrating the relationship with an output voltage $V_{out}$ according to a difference $V_{in1}-V_{in2}$ in voltage between two input terminals of a differential amplifier illustrated in FIG. 2, when the difference $V_{in1}-V_{in2}$ in voltage between the two input terminals is 0, a voltage level $V_{out}$ of an output terminal does not become 0 and has an error equal to an offset $V_{os}$. That is, the output voltage $V_{out}$ will be 0 only when the difference $V_{in1}-V_{in2}$ in voltage between the two input terminals of the differential amplifier 100 illustrated in FIG. 1 becomes a value called the offset voltage Vos.

The offset voltage of the differential amplifier has different values depending on the manufacturing process of the differential amplifier, and even for the differential amplifiers manufactured by the same manufacturing process, a size of the offset voltage is different, so it is impossible for a circuit designer to uniformly select the compensation of the offset voltage. However, in order to implement electrical characteristics of the circuit to be achieved, the offset of the differential amplifier included in the circuit should be supplemented or canceled within the circuit.

## SUMMARY

The object is of the invention is to provide an offset free differential amplifier and an offset free method capable of removing the offset of the differential amplifier.

The basic idea to solve this object is to selectively use at least one of an auto zero method and a chopping method.

Objects of the present invention are not limited to the above-mentioned objects. That is, other objects that are not mentioned may be obviously understood by those skilled in the art to which the present invention pertains from the following description.

The object is solved by the features of the independent claims. Preferred embodiments are given in the dependent claims.

According to an aspect of the present invention, an offset free differential amplifier includes a differential amplifier; a chopping switch unit that is connected to two input terminals and one output terminal of the differential amplifier in response to a chopping control signal and removes an average offset of the differential amplifier; and an auto-zero switch unit that is connected to the differential amplifier and the chopping switch unit in response to an auto-zero switch control signal and removes an absolute offset of the differential amplifier.

According to another aspect of the present invention, an offset free method of a differential amplifier relates to an offset free method of a differential amplifier including differential amplifier, a chopping switch unit, and an auto-zero switch unit, the offset free method including at least one of removing an average offset of the differential amplifier and removing an absolute offset of the differential amplifier using the chopping switch unit and the auto-zero switch unit.

In one or more embodiments, the chopping switch unit may include a first transmission gate that electrically connects or disconnects a signal input terminal and a positive input terminal of the differential amplifier in response to a first chopping control signal.

In one or more embodiments, the chopping switch unit may further include a second transmission gate that electrically connects or disconnects a first node and a negative input terminal of the differential amplifier in response to a second chopping control signal.

In one or more embodiments, the chopping switch unit may include a third transmission gate that electrically connects or disconnects the positive input terminal of the differential amplifier and the output terminal of the differential amplifier in response to an inverse first chopping control signal that inverts a phase of the first chopping control signal.

In one or more embodiments, the chopping switch unit may include a fourth transmission gate that electrically connects or disconnects the negative input terminal of the differential amplifier and the output terminal of the differential amplifier in response to the first chopping control signal.

In one or more embodiments, the auto-zero switch unit may include a capacitor that is installed between the first node and the second node; a first auto-zero switch that switches the signal input terminal and the second node in response to a first auto-zero switch control signal; a second auto-zero switch that switches the first node and the output terminal of the differential amplifier in response to a second auto-zero switch control signal; a fourth auto-zero switch that switches the second node to an output terminal of an offset free differential amplifier in response to a fourth auto-zero switch control signal; and a fifth auto-zero switch that switches the output terminal of the differential amplifier to the output terminal of the offset free differential amplifier in response to a fifth auto-zero switch control signal.

In the following optional features will be provided which can be combined with the above mentioned aspects, independently or in combination or sub-combination.

In one or more embodiments, the chopping switch may include a first transmission gate configured to electrically connect or disconnect a signal input terminal and a positive input terminal of the differential amplifier in response to a first chopping control signal.

In one or more embodiments, the chopping switch may further include a second transmission gate configured to electrically connect or disconnect a first node and a negative input terminal of the differential amplifier in response to a second chopping control signal.

In one or more embodiments, the chopping switch may further include a third transmission gate configured to electrically connect or disconnect the positive input terminal of the differential amplifier and the output terminal of the differential amplifier in response to an inverse first chopping control signal that inverts a phase of the first chopping control signal.

In one or more embodiments, the auto-zero switch unit may include a capacitor that is installed between the first node and a second node; a first auto-zero switch that may switch the signal input terminal and the second node in response to a first auto-zero switch control signal; a second auto-zero switch configured to switch the first node and the output terminal of the differential amplifier in response to a second auto-zero switch control signal; a fourth auto-zero switch configured to switch the second node to an output terminal of an offset free differential amplifier in response to a fourth auto-zero switch control signal; and a fifth auto-zero switch configured to switch the output terminal of the differential amplifier to the output terminal of the offset free differential amplifier in response to a fifth auto-zero switch control signal

In one or more embodiments, the auto-zero switch unit may further include a third auto-zero switch configured to switch the first node to the output terminal of the offset free differential amplifier in response to a third auto-zero switch control signal.

In one or more embodiments, when removing a relative offset of the differential amplifier, the offset of the differential amplifier is sampled during one section, and the sampled offset is removed during a next one section,

In one or more embodiments, the turn-on and turn-off operations of the first and the fourth transmission gate during the one section and the next one section, and turn-on and turn-off operations of the second transmission gate and the fourth transmission gate are each performed identically in pairs.

In one or more embodiments, the removing of the average offset may alternately perform sampling an offset of the differential amplifier; and removing the sampled offset.

In one or more embodiments, in the sampling, the first transmission gate, the fourth transmission gate, and the fifth auto-zero switch may be turned on, and the second transmission gate, the third transmission gate, the first auto-zero switch, the second auto-zero switch, and the fourth auto-zero switch may be turned off.

In one or more embodiments in the removing of the offset, the second transmission gate, the third transmission gate, the first auto-zero switch, and the fifth auto-zero switch are turned on, and the first transmission gate, the fourth transmission gate, the second auto-zero switch, and the fourth auto-zero switch may be turned off.

In one or more embodiments the removing of the absolute offset may alternately perform sampling the offset of the differential amplifier; and removing the sampled offset.

In one or more embodiments in the sampling, the first transmission gate, the fourth transmission gate, the first auto-zero switch, and the second auto-zero switch are turned on, and the second transmission gate, the third transmission gate, the fourth auto-zero switch, and the fifth auto-zero switch may be are turned off.

In one or more embodiments in the removing of the offset, the first transmission gate, the second transmission gate, the fourth transmission gate, the fourth auto-zero switch, and the fifth auto-zero switch are turned on, and the third transmission gate, the first auto-zero switch, and the second auto-zero switch may be turned off.

In one or more embodiments the removing of the average offset and the removing of the absolute offset are performed sequentially.

In one or more embodiments the auto-zero switch unit may further include a third auto-zero switch that switches the first node to the output terminal of the offset free differential amplifier in response to a third auto-zero switch control signal.

In one or more embodiments the simultaneously removing of the average offset and the absolute offset may alternately perform sampling the offset of the differential amplifier; and removing the sampled offset.

In one or more embodiments, in the sampling, the first transmission gate, the fourth transmission gate, the first auto-zero switch, the second auto-zero switch, and the third auto-zero switch are turned on, and the second transmission gate, the third transmission gate, the fourth auto-zero switch, and the fifth auto-zero switch may be turned off.

In one or more embodiments in the removing of the offset, the second transmission gate, the third transmission gate, the first auto-zero switch, and the fourth auto-zero switch may be turned on, and the first transmission gate, the fourth transmission gate , the second auto-zero switch, the third auto-zero switch, and the fifth auto-zero switch may be turned off.

Objects of the present invention are not limited to the above-described objects. That is, other objects that are not described may be obviously understood by those skilled in the art to which the present invention pertains from the following description.

## BRIEF DESCRIPTION OF DRAWINGS

FIG. 1 is an equivalent model of a conventional differential amplifier.
FIG. 2 is a graph for describing a concept of an offset voltage of a differential amplifier.
FIG. 3 is an example of an offset free differential amplifier according to the present invention.
FIG. 4 is an example of a switch control signal generator used in the offset free differential amplifier illustrated in FIG. 3.
FIG. 5 is a table illustrating open/closed states of a plurality of switches illustrated in FIG. 3 when the offset of the differential amplifier is removed using an auto-zero method, a chopping method, and a merging method.

FIG. 6 is a timing diagram of the corresponding switch control signal when the offset free differential amplifier illustrated in FIG. 3 removes the offset using the auto-zero method.
FIG. 7 is a diagram illustrating a circuit for offset sampling when removing the offset using the auto-zero method.
FIG. 8 is a diagram illustrating a circuit for offset removal when removing the offset using the auto-zero method.
FIG. 9 is a timing diagram of the corresponding switch control signal when the offset free differential amplifier illustrated in FIG. 3 removes the offset using the chopping method.
FIG. 10 is a diagram illustrating a circuit for primary signal processing when removing the offset of the differential amplifier using the chopping method.
FIG. 11 is a diagram illustrating a circuit for secondary signal processing when removing the offset of the differential amplifier using the chopping method.
FIG. 12 is a timing diagram of the corresponding switch control signal when the offset free differential amplifier illustrated in FIG. 3 removes the offset using the auto-zero method.
FIG. 13 is a diagram illustrating a circuit for offset sampling when removing the offset of the differential amplifier by simultaneously performing the auto-zero method and the chopping method.
FIG. 14 is a diagram illustrating a circuit for offset removal when removing the offset of the differential amplifier by simultaneously performing the auto-zero method and the chopping method.

## DETAILED DESCRIPTION

In order to sufficiently understand the present invention, operational advantages of the present invention, and objects accomplished by exemplary embodiments of the present invention, the accompanying drawings for describing exemplary embodiments of the present invention and contents described in the accompanying drawings should be referred to.

Hereinafter, exemplary embodiments of the present invention will be described in detail with reference to the accompanying drawings. Like reference numerals proposed in each drawing denote like components.

FIG. 3 is an example of an offset free differential amplifier according to the present invention.

Referring to FIG. 3, an offset free differential amplifier (AMP) 300 according to the present invention includes a differential amplifier 310, a chopping switch unit 320, and an auto-zero switch unit 330.

The chopping switch unit 320 includes a plurality of switches TG1 to TG4 that remove an average offset of the differential amplifier 310 in response to a first chopping control signal CHOP1 and a second chopping control signal CHOP2. Here, the average offset of the differential amplifier 310 is used as a concept in contrast to the absolute offset of the differential amplifier 310.

Among the methods for removing the offset of the differential amplifier 310, a method of removing an average offset removes the offset by sequentially reflecting an absolute value of an input signal, that is, offsets with opposite signs. A method of removing an absolute offset prestores a unique offset of the differential amplifier 310 using a storage means such as a capacitor and then reflects the pre-stored unique offset inversely during signal processing, thereby removing the offset of the differential amplifier 310 from the processed signal.

A first transmission gate TG1 that electrically connects or disconnects a signal input terminal $V_{in}$ and a positive input terminal + of the differential amplifier 310 in response to a first chopping control signal CHOP1. Here, the expression of responding to the first chopping control signal CHOP1 means that the first transmission gate TG1 electrically connects the signal input terminal $V_{in}$ to the positive input terminal + of the differential amplifier 310 when the first chopping control signal CHOP1 is in a logic high state, and conversely, disconnects between the signal input terminal $V_{in}$ and the positive input terminal + of the differential amplifier 310, which are already electrically connected, when the first chopping control signal CHOP1 is in a logic low state.

A second transmission gate TG2 electrically connects or disconnects a first node N1 and a negative input terminal - of the differential amplifier 310 in response to the second chopping control signal CHOP2.

A third transmission gate TG3 electrically connects or disconnects the positive input terminal + of the differential amplifier 310 and an output terminal $V_{O1}$ of an amplifier in response to an inverse first chopping control signal CHOP1. Here, the expression of responding to the inverse first chopping control signal CHOP1 means electrically connecting the positive input terminal + and the output terminal $V_{O1}$ of the differential amplifier 310 when the first chopping control signal CHOP1 is in the logic low state, and conversely, disconnecting between the positive input terminal + and the output terminal $V_{O1}$ of the differential amplifier 310, which are already electrically connected, when the first chopping control signal CHOP1 is in the logic high state.

A fourth transmission gate TG4 electrically connects or disconnects a negative input terminal - of the differential amplifier 310 and the output terminal $V_{O1}$ of the amplifier in response to the first chopping control signal CHOP1.

For simplicity of description, in the following description, a function of electrically connecting or disconnecting two terminals is expressed as switching.

The auto-zero switch unit 330 includes a plurality of auto-zero switches SW1 to SW5 and a capacitor C that removes the absolute offset of the differential amplifier 310 in response to a plurality of switch control signals SC1 to SC5, and a capacitor C.

The capacitor C is installed between a first node N1 and a second node N2.

The first auto-zero switch SW1 switches the signal input terminal $V_{in}$ and the second node N2 in response to the first auto-zero switch control signal SC1.

The second auto-zero switch SW2 switches the first node N1 and the output terminal Voi of the amplifier in response to the second auto-zero switch control signal SC2.

The third auto-zero switch SW3 switches the first node N1 to an output terminal $V_{out}$ of the offset free differential amplifier in response to the third auto-zero switch control signal SC3.

The fourth auto-zero switch SW4 switches the second node N2 to the output terminal $V_{out}$ of the offset free differential amplifier in response to the fourth auto-zero switch control signal SC4.

The fifth auto-zero switch SW5 switches the output terminal $V_{O1}$ of the amplifier to the output terminal $V_{out}$ of the offset free differential amplifier in response to the fifth auto-zero switch control signal SC5.

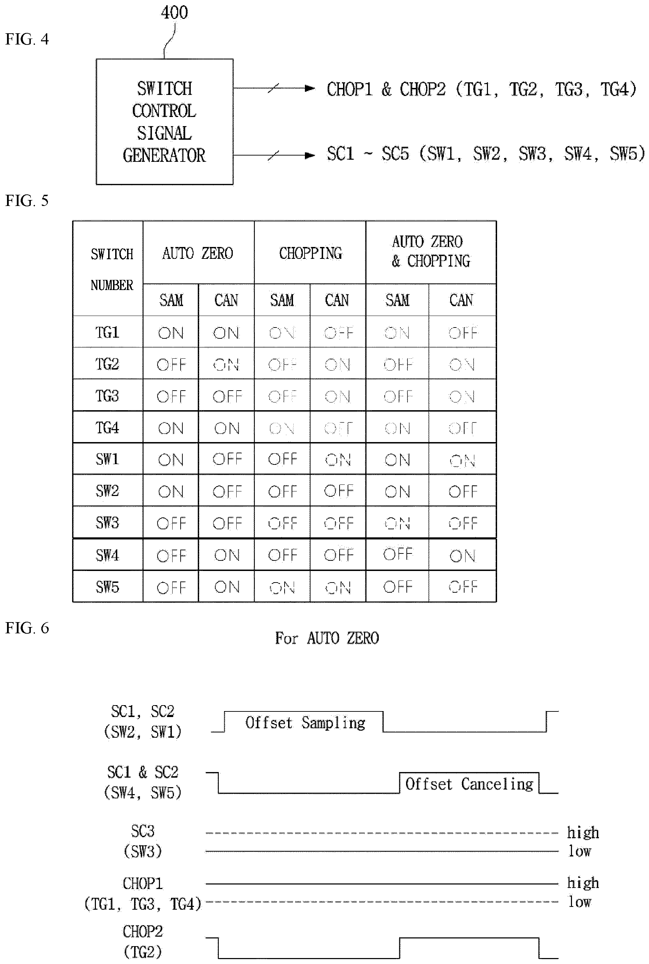

FIG. 4 is an example of a switch control signal generator used in the offset free differential amplifier illustrated in FIG. 3.

Referring to FIG. 4, a switch control signal generator 400 generates the first chopping control signal CHOP1 and the second chopping control signal CHOP2 applied to four transmission gates TG1 to TG4, and generates five auto-zero switch control signals SC1 to SW5 that are applied to the auto-zero switches SW1 to SW5.

The offset free differential amplifier 300 according to the present invention illustrated in FIG. 3 of the present invention includes a chopping switch unit 320 and an auto-zero switch unit 330, in which the chopping switch unit 320 and the auto-zero switch unit 330 may be used to exclusively remove, sequentially remove, or remove the offset of the differential amplifier 310 by merging. Here, the expression "exclusively" means that when one of the chopping switch unit 320 and the auto-zero switch unit 330 is activated and performs the process of removing the offset of the differential amplifier 310, the other does not perform a process of removing the offset.

The expression "sequentially removing the offset" means that one of the chopping switch unit 320 and the auto-zero switch unit 330 first removes the offset of the differential amplifier 310, and then the other removes the offset of the differential amplifier 310.

The expression "finally removing the offset by merging" means that the chopping switch unit 320 and the auto-zero switch unit 330 are activated simultaneously to remove the offset of the differential amplifier 310.

FIG. 5 is a table illustrating open/closed states of a plurality of switches illustrated in FIG. 3 when the offset of the differential amplifier is removed using an auto-zero method, a chopping method, and a merging method.

The process of removing offset using the auto-zero method, the chopping method, and the merging method using the open/closed state of the switch illustrated in FIG. 5 will be described.

First, the method of activating the auto-zero switch unit 330 to remove the offset of the differential amplifier 310 using the auto-zero method will be described.

FIG. 6 is a timing diagram of the corresponding switch control signal when the offset free differential amplifier illustrated in FIG. 3 removes the offset using the auto-zero method.

FIG. 6 is a timing diagram illustrating states of a plurality of switches illustrated in the table of FIG. 5. It can be seen that the offset removal process sequentially performs offset sampling and offset canceling.

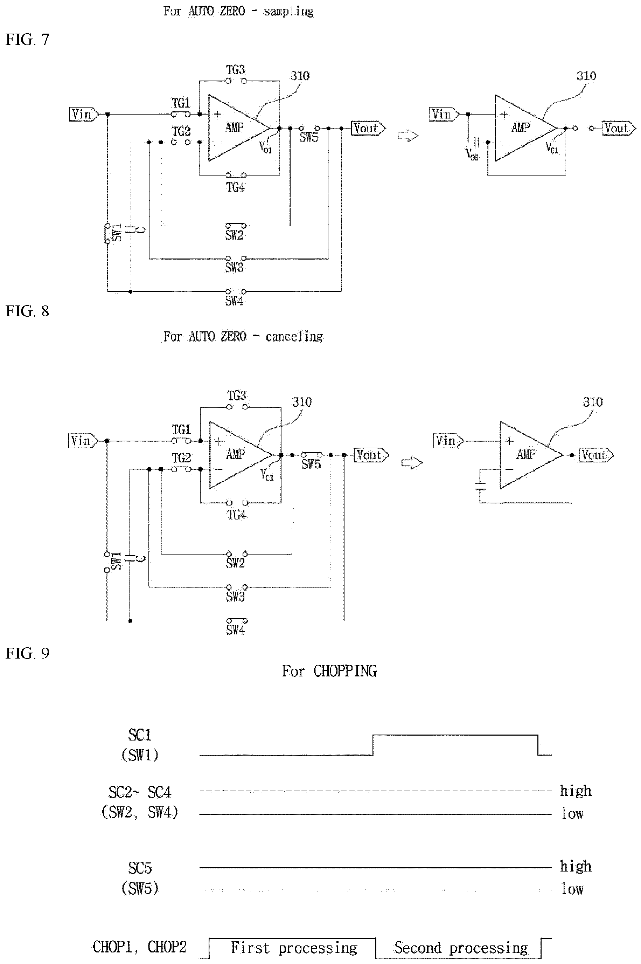

FIG. 7 is a diagram illustrating a circuit for offset sampling when removing the offset using the auto-zero method.

In FIG. 7, the left side illustrates the connection state of the switch, and the right side schematically illustrates only the connection state of the left circuit. Since the open/closed state of the switch may be understood with reference to FIG. 5, the open/closed state of the switch will not be described in detail here. The description of the circuit illustrated in FIG. 7 will be applied equally to similar circuits hereinafter without special description.

Referring to the right circuit of FIG. 7, it may be seen that the input terminal + of the differential amplifier 310 is connected to the signal input terminal $V_{in}$, and the negative input terminal - and the differential amplifier 310 operates as a buffer for the signal applied to the signal input terminal $V_{in}$. In particular, the capacitor C is installed between the signal input terminal $V_{in}$ of the differential amplifier 310 and the negative input terminal - of the differential amplifier 310, and the input terminals + and - are in a virtual ground state, so an offset voltage Vos of the differential amplifier 310 will drop on the capacitor C.

Referring to FIG. 7, it can be seen that in the offset sampling step, the output voltage $V_{out}$ of the differential amplifier 310 is not directly transmitted to the output terminal $V_{out}$ of the offset free differential amplifier 300, but remains at the internal amplifier output terminal Voi.

FIG. 8 is a diagram illustrating a circuit for offset removal when removing the offset using the auto-zero method.

Referring to the right side of FIG. 8, unlike the circuit illustrated on the right side of FIG. 7, it can be seen that, regarding the offset of the differential amplifier 310 sampled at the capacitor C, the input signal $V_{in}$ with the offset of the differential amplifier 310 removed is amplified at the output terminal $V_{out}$ of the offset free differential amplifier 300 by allowing the capacitor C storing the offset $V_{OS}$ to be included in negative feedback.

FIG. 9 is a timing diagram of the corresponding switch control signal when the offset free differential amplifier illustrated in FIG. 3 removes the offset using the chopping method.

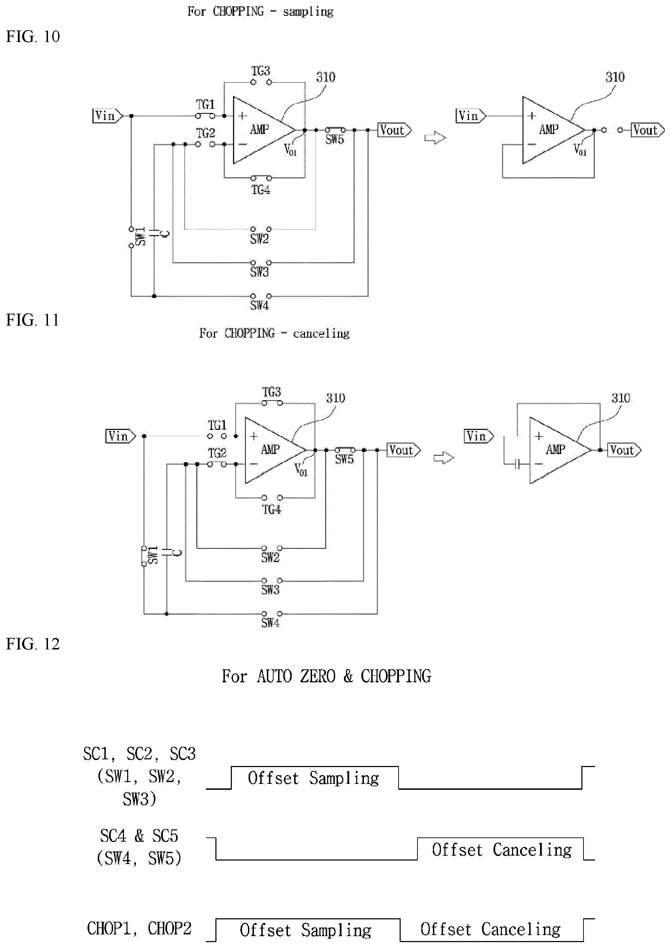

FIG. 10 is a diagram illustrating a circuit for primary signal processing when removing the offset of the differential amplifier using the chopping method.

FIG. 11 is a diagram illustrating a circuit for secondary signal processing when removing the offset of the differential amplifier using the chopping method.

The left sides of FIGS. 10 and 11 illustrate the connection state of the switch, and the right sides schematically illustrate only the connection state of the left circuit. The open/closed state of the switch may be understood with reference to FIG. 5.

Referring to the right circuits of FIGS. 10 and 11, respectively, it may be seen that when applying the chopping method, the differential amplifier 310 is converted into a buffer form to operate, and when performing the primary signal processing and the secondary signal processing, the input signal $V_{in}$ is applied to the two input terminals of the differential amplifier 310, so it is possible to sequentially perform the two signal processing and ultimately relatively cancel the offset of the differential amplifier 310 with respect to the input signal $V_{in}$.

As described above, the offset free differential amplifier 300 according to the present invention illustrated in FIG. 3 may use the chopping switch unit 320 and the auto-zero switch unit 330 connected to the input and output terminals of the differential amplifier 310 to remove the offsets of the differential amplifier 310 with respect to the input signal $V_{in}$, respectively.

As described above, the chopping switch unit 320 and the auto-zero switch unit 330 can be selectively applied to the differential amplifier 310, but can also be applied sequentially. In other words, it is possible to use the chopping switch unit 320 for a part of the total time section in which the input signal $V_{in}$ is processed, and to use the auto-zero switch unit 330 for the remaining time, and vice versa.

Of course, it is also possible to simultaneously use the chopping switch unit 320 and the auto-zero switch unit 330. In the present invention, when the chopping switch unit 320 and the auto-zero switch unit 330 are used simultaneously, it is proposed to utilize the third auto-zero switch SW3 in the auto-zero switch unit 330 so that additional offset is prevented from occurring by the plurality of switches included in the chopping switch unit 320 and the auto-zero switch unit 330.

FIG. 12 is a timing diagram of the corresponding switch control signal when the offset free differential amplifier illustrated in FIG. 3 removes the offset using the auto-zero method.

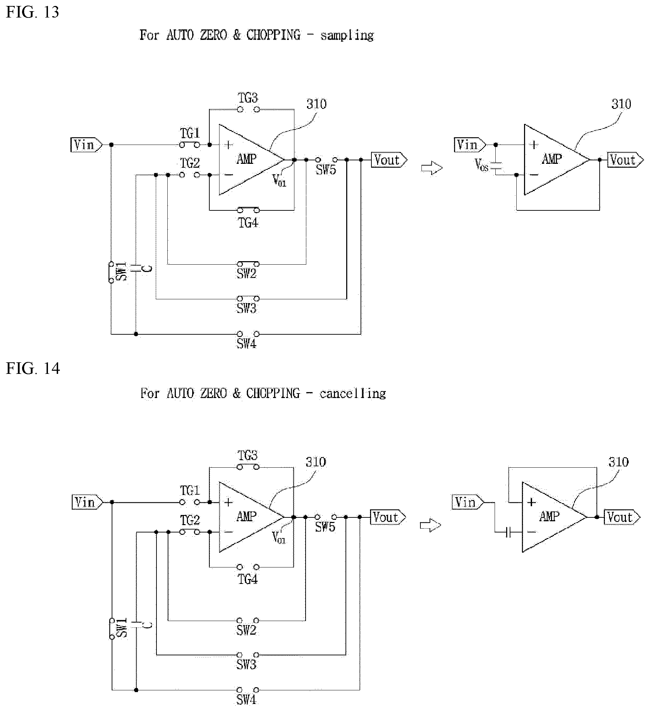

FIG. 13 is a diagram illustrating a circuit for offset sampling when removing the offset of the differential amplifier by simultaneously performing the auto-zero method and the chopping method.

FIG. 14 is a diagram illustrating a circuit for offset removal when removing the offset of the differential amplifier by simultaneously performing the auto-zero method and the chopping method.

Referring to FIG. 5, it can be seen that when the offset free differential amplifier 300 according to the present invention separately uses the auto-zero method and the chopping method, the third auto-zero switch SW3 is always turned off, but when the auto-zero method and the chopping method are performed simultaneously, turn-on (ON) and turn-off (OFF) are performed alternately.

The right drawings of FIGS. 13 and 14 may be easily understood by referring to the drawings illustrated in FIGS. 6 to 11, and therefore, will not be described in detail here. However, referring to the left drawings of FIGS. 13 and 14, it can be seen that the third auto-zero switch SW3 is in a turned on state in the offset sampling step, but the third auto-zero switch SW3 is in a turned off state in the offset removing step.

As described above, according to an offset free differential amplifier according to the present invention, it is possible to remove the offset by using at least one of an auto-zero method and a chopping method of a single differential amplifier, and prevent an offset by an internal switch from being additionally occurring.

Effects which can be achieved by the present invention are not limited to the above-described effects. That is, other objects that are not described may be obviously understood by those skilled in the art to which the present invention pertains from the following description.

In the above description, the technical idea of the present invention has been described along with the accompanying drawings, but this is an exemplary description of a preferred embodiment of the present invention and does not limit the present invention. In addition, it is clear that anyone skilled in the art of the present invention can make various modifications and imitations without departing from the scope of the technical idea of the present invention.

**Claims**

1. An offset free differential amplifier, comprising:

   a differential amplifier (310);
   a chopping switch unit (320) that is connected to two input terminals and one output terminal of the differential amplifier (310), the chopping switch unit (320) is configured to remove an average offset of the differential amplifier (310) in response to a chopping control signal (CHOP); and
   an auto-zero switch unit (330) that is connected to the differential amplifier (310) and the chopping switch unit (320), the auto-zero switch unit (330) is configured to remove an absolute offset of the differential amplifier in response to an auto-zero switch control signal (SC).

2. The offset free differential amplifier of claim 1, wherein the chopping switch unit (320) includes:

   a first transmission gate (TG1) configured to electrically connect or disconnect a signal input terminal ($V_{in}$) and a positive input terminal of the differential amplifier in response to a first chopping control signal (CHOP1);
   a second transmission gate (TG2) configured to electrically connect or disconnect a first node (N1) and a negative input terminal of the differential amplifier (310) in response to a second chopping control signal (CHOP2);
   a third transmission gate (TG3) configured to electrically connect or disconnect the positive input terminal of the differential amplifier (310) and the output terminal of the differential amplifier (310) in response to an inverse first chopping control signal that inverts a phase of the first chopping control signal (CHOP1); and
   a fourth transmission gate (TG4) configured to electrically connect or disconnect the negative input terminal of the differential amplifier and the output terminal of the differential amplifier in response to the first chopping control signal (CHOP1).

3. The offset free differential amplifier of claim 1 or 2, wherein the auto-zero switch unit (330) includes:

   a capacitor (C) that is installed between the first node (N1) and a second node (N2);
   a first auto-zero switch (SW1) that switches the signal input terminal and the second node (N2) in response to a first auto-zero switch control signal (SC1);
   a second auto-zero switch (SW2) configured to switch the first node (N1) and the output terminal of the differential amplifier (310) in response to a second auto-zero switch control signal (SC2);
   a fourth auto-zero switch (SW4) configured to switch the second node (N2) to an output terminal of an offset free differential amplifier (300) in response to a fourth auto-zero switch control signal (SC4); and
   a fifth auto-zero switch (SW5) configured to switch the output terminal of the differential amplifier (310) to the output terminal of the offset free differential amplifier (300) in response to a fifth auto-zero switch control signal (SC5).

4. The offset free differential amplifier of claim 1, 2 or 3, wherein the auto-zero switch unit (330) further includes a third auto-zero switch (SW3) configured to switch the first node (N1) to the output terminal of the offset free differential amplifier (310) in response to a third auto-zero switch control signal (SC3).

5. The offset free differential amplifier of any one of the preceding claims, wherein when removing a relative offset of the differential amplifier (310), the offset of the differential amplifier (310) is sampled during one section, and the sampled offset is removed during a next one section, and

wherein turn-on and turn-off operations of the first transmission gate (TG1) and the fourth transmission gate (TG4) during the one section and the next one section, and turn-on and turn-off operations of the second transmission gate (TG2) and the fourth transmission gate (TG3) are each performed identically in pairs.

6. An offset free method of a differential amplifier including a differential amplifier (310), a chopping switch unit (320) that removes an average offset of the differential amplifier in response to a chopping control signal (CHOP), and an auto-zero switch unit (330) that removes an absolute offset of the differential amplifier in response to an auto-zero switch control signal (SC), the offset free method comprising:

at least one of removing the average offset of the differential amplifier and removing the absolute offset of the differential amplifier using the chopping switch unit (320) and the auto-zero switch unit (330).

7. The offset free method of claim 6, wherein the chopping switch unit (320) includes a first transmission gate (TG1) that electrically connects or disconnects a signal input terminal and a positive input terminal of the differential amplifier in response to a first chopping control signal (CHOP1); a second transmission gate (TG2) that electrically connects or disconnects a first node (N1) and a negative input terminal of the differential amplifier in response to a second chopping control signal (CHOP2); a third transmission gate (TG3) that electrically connects or disconnects the positive input terminal of the differential amplifier and an output terminal of the differential amplifier in response to an inverse first chopping control signal that inverts a phase of the first chopping control signal (CHOP1); and a fourth transmission gate (TG4) that electrically connects or disconnects the negative input terminal of the differential amplifier and the output terminal of the differential amplifier in response to the first chopping control signal,

and wherein the auto-zero switch unit (330) includes a capacitor (C) that is installed between the first node (N1) and an second node (N2); a first auto-zero switch (SW1) that switches the signal input terminal and the second node (N2) in response to a first auto-zero switch control signal (SC1); a second auto-zero switch (SW2) that switches the first node (N1) and the output terminal of the differential amplifier (310) in response to a second auto-zero switch control signal (SC2); a fourth auto-zero switch (SW4) that switches the second node (N2) to an output terminal of an offset free differential amplifier (300) in response to a fourth auto-zero switch control signal (SC4); and a fifth auto-zero switch (SW5) that switches the output terminal of the differential amplifier (310) to the output terminal of the offset free differential amplifier (300) in response to a fifth auto-zero switch control signal (SC5).

8. The offset free method of claim 6 or 7, wherein the removing of the average offset alternately performs sampling an offset of the differential amplifier; and removing the sampled offset.

9. The offset free method of claim 7 or 8, wherein in the sampling, the first transmission gate (TG1), the fourth transmission gate (TG4), and the fifth auto-zero switch (SW5) are turned on, and the second transmission gate (TG2), the third transmission gate (TG3), the first auto-zero switch (SW1), the second auto-zero switch (SW2), and the fourth auto-zero switch (SW4) are turned off, and wherein in the removing of the offset, the second transmission gate (TG2), the third transmission gate (TG3), the first auto-zero switch (SW1), and the fifth auto-zero switch (SW5) are turned on, and the first transmission gate (TG1), the fourth transmission gate (TG4), the second auto-zero switch (SW2), and the fourth auto-zero switch (SW4) are turned off.

10. The offset free method of any one of the preceding claims 6-9, wherein the removing of the absolute offset alternately performs sampling the offset of the differential amplifier; and removing the sampled offset.

11. The offset free method of any one of the preceding claims 7-10,

wherein in the sampling, the first transmission gate (TG1), the fourth transmission gate (TG4), the first auto-zero switch (SW1), and the second auto-zero switch (SW2) are turned on, and the second transmission gate (TG2), the third transmission gate (TG3), the fourth auto-zero switch (SW4), and the fifth auto-zero switch (SW5) are turned off, and wherein in the removing of the offset, the first transmission gate (TG1), the second transmission gate (TG2), the fourth transmission gate (TG4), the fourth auto-zero switch (SW4), and the fifth auto-zero switch (SW5) are turned on, and the third transmission gate (TG3), the first auto-zero switch (SW1), and the second auto-zero switch (SW2) are turned off.

12. The offset free method of any one of the preceding claims 7-11, wherein the removing of the average offset and the removing of the absolute offset are performed sequentially.

13. The offset free method of any one of the preceding claims 7-12, wherein the auto-zero switch unit (330) further includes a third auto-zero switch (SW3) that switches the first node to the output terminal of the offset free differential amplifier in response to a third auto-zero switch control signal (SC3).

14. The offset free method of claim 13, wherein the simultaneously removing of the average offset and the absolute offset alternately performs sampling the offset of the differential amplifier; and removing the sampled offset.

15. The offset free method of claim 14,

wherein in the sampling, the first transmission gate (TG1), the fourth transmission gate (TG4), the first auto-zero switch (SW1), the second auto-zero switch (SW2), and the third auto-zero switch (SW3) are turned on, and the second transmission gate (TG2), the third transmission gate (TG3), the fourth auto-zero switch (SW4), and the fifth auto-zero switch (SW5) are turned off,
and/or
wherein in the removing of the offset, the second transmission gate (TG2), the third transmission gate (TG3), the first auto-zero switch (SW1), and the fourth auto-zero switch (SW4) are turned on, and the first transmission gate (TG1), the fourth transmission gate (TG4), the second auto-zero switch (SW2), the third auto-zero switch (SW3), and the fifth auto-zero switch (SW5) are turned off.

FIG. 1

100

$$V_{in1} \quad +$$

$$A(V_{in1} - V_{in2}) \quad V_{out}$$

$$V_{in2} \quad -$$

FIG. 2

$$V_{out}$$

$$V_{in1} - V_{in2}$$

$$V_{os}$$

FIG. 3

300

320

CHOP1

TG3

CHOP1

310    330

TG1    CHOP1

Vin    +    SC5

AMP    SW5    Vout

N1    TG2    -

CHOP2    $V_{01}$

TG4    CHOP1

SC1    SC2

SW1    C    SW2

SC3

SW3

SC4

N2    SW4

FIG. 4

400

```
┌─────────────┐
│   SWITCH    │ ──/──►  CHOP1 & CHOP2 (TG1, TG2, TG3, TG4)
│  CONTROL    │
│   SIGNAL    │
│  GENERATOR  │ ──/──►  SC1 ~ SC5 (SW1, SW2, SW3, SW4, SW5)
└─────────────┘
```

FIG. 5

| SWITCH NUMBER | AUTO ZERO | | CHOPPING | | AUTO ZERO & CHOPPING | |
|---|---|---|---|---|---|---|
| | SAM | CAN | SAM | CAN | SAM | CAN |
| TG1 | ON | ON | ON | OFF | ON | OFF |
| TG2 | OFF | ON | OFF | ON | OFF | ON |
| TG3 | OFF | OFF | OFF | ON | OFF | ON |
| TG4 | ON | ON | ON | OFF | ON | OFF |
| SW1 | ON | OFF | OFF | ON | ON | ON |
| SW2 | ON | OFF | OFF | OFF | ON | OFF |
| SW3 | OFF | OFF | OFF | OFF | ON | OFF |
| SW4 | OFF | ON | OFF | OFF | OFF | ON |
| SW5 | OFF | ON | ON | ON | OFF | OFF |

FIG. 6

For AUTO ZERO

SC1, SC2
(SW2, SW1)        Offset Sampling

SC1 & SC2
(SW4, SW5)                        Offset Canceling

SC3
(SW3)                                               high
                                                     low

CHOP1                                                high
(TG1, TG3, TG4)                                      low

CHOP2
(TG2)

For AUTO ZERO - sampling

FIG. 7

FIG. 8

For AUTO ZERO - canceling

FIG. 9

For CHOPPING

For CHOPPING - sampling

FIG. 10

FIG. 11

For CHOPPING - canceling

FIG. 12

For AUTO ZERO & CHOPPING

SC1, SC2, SC3
(SW1, SW2, SW3) — Offset Sampling

SC4 & SC5
(SW4, SW5) — Offset Canceling

CHOP1, CHOP2 — Offset Sampling — Offset Canceling

FIG. 13

For AUTO ZERO & CHOPPING - sampling

FIG. 14

For AUTO ZERO & CHOPPING - cancelling

Europäisches
Patentamt

European
Patent Office

Office européen
des brevets

**EUROPEAN SEARCH REPORT**

Application Number

EP 23 21 2255

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2010/289568 A1 (ESCHAUZIER RUDY G H [NL] ET AL) 18 November 2010 (2010-11-18) * paragraphs [0058] – [0059] * * figure 5 * ----- | 1-15 | INV. H03F3/387 H03F3/45 H03F3/347 |
| X | US 2008/106330 A1 (YOSHIDA TAKESHI [JP] ET AL) 8 May 2008 (2008-05-08) * figure 3 * ----- | 1-15 | |

TECHNICAL FIELDS SEARCHED (IPC)

H03F

The present search report has been drawn up for all claims

| Place of search | Date of completion of the search | Examiner |
|---|---|---|
| The Hague | 19 April 2024 | Rocha, Daniel |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

        .......................................................................
& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 23 21 2255

This annex lists the patent family members relating to the patent documents cited in  the above-mentioned European search report.
The members are as contained in the European Patent Office EDP file on
The European Patent Office is in no way liable for these particulars which are merely given for the purpose of information.

19-04-2024

| Patent document cited in search report | | Publication date | Patent family member(s) | | Publication date |
|---|---|---|---|---|---|
| US 2010289568 | A1 | 18-11-2010 | CN 101895257 | A | 24-11-2010 |
| | | | EP 2251977 | A2 | 17-11-2010 |
| | | | US 2010289568 | A1 | 18-11-2010 |
| US 2008106330 | A1 | 08-05-2008 | JP 4354473 | B2 | 28-10-2009 |
| | | | JP 2008067050 | A | 21-03-2008 |
| | | | US 2008106330 | A1 | 08-05-2008 |

EPO FORM P0459

For more details about this annex : see Official Journal of the European Patent Office, No. 12/82